# EUROPEAN PATENT SPECIFICATION

(11) **EP 1 250 470 B1**
(45) Date of publication and mention of the grant of the patent: **03.09.2003**
(21) Application number: 01946906.3
(22) Date of filing: 29.01.2001
(51) Int. Cl.: C23C 14/14, C23C 14/22, H01F 41/14

(54) **NANO-MATERIAL**
NANO-MATERIAL
NANO-MATERIAU

(30) Priority: 28.01.2000 GB 0001950
(43) Date of publication of application: 23.10.2002
(73) Proprietor: Council for the Central Laboratory of the Research Councils, Warrington, Cheshire WA4 4AD (GB)
(72) Inventor: EASTHAM, Derek, Warrington, WA4 4AD (GB)
(74) Representative: Holmes, Matthew Peter
(86) International application number: GB0100361
(87) International publication number: WO01055474

(56) References cited:
- US-A- 5 462 809
- US-A- 5 858 125
- HAMAKAKE H ET AL: "PREPARATION OF FE/AG GRANULAR FILMS BY LOW ENERGY CLUSTER DEPOSITION" IEEE TRANSACTIONS ON MAGNETICS,IEEE INC. NEW YORK,US, vol. 35, no. 5, PART 02, September 1999 (1999-09), pages 3457-3459, XP000867964 ISSN: 0018-9464
- PATENT ABSTRACTS OF JAPAN vol. 1995, no. 01, 28 February 1995 (1995-02-28) & JP 06 283332 A (HITACHI LTD), 7 October 1994 (1994-10-07)

## Description

The present invention relates to a nano-material, and in particular to a nano-material provided as a thin film.

Nano-materials have been fabricated in many laboratories around the world. A polycrystalline nano-material is generally considered to be one in which the grain size of the polycrystalline material is 100 nanometers or less. A nano-material may be provided as a thin film, which typically comprises a layer of material less than 100 nanometers thick. A thin film nano-material may be constructed using for example chemical vapour deposition or atomic deposition.

Nano-materials are the subject of a considerable amount of research. It is known that the properties of a material will be modified considerably when it is structured on a nanometer scale. For example, dramatic increases in hardness occur when the grain size of a polycrystalline material is reduced to a nanometer scale. Furthermore, it is known that the band gap of a polycrystalline semiconductor will increase as the diameter of semiconductor crystals is reduced below about 4 nanometers.

It is an object of the present invention to provide a novel method of producing a thin film nano-material.

According to a first aspect of the invention there is provided a method of making a nano-material, the method comprising simultaneously depositing atoms of a ferro-magnetic substance together with clusters of atoms of a non-magnetic substance onto a surface, thereby providing a nano-material comprising a polycrystaline matrix of grains of the ferro-magnetic substance surrounded by clusters of atoms of the non-magnetic substance.

The simultaneous atomic and cluster deposition of the magnetic and non-magnetic materials allows the morphology of the resultant material to be carefully controlled.

The nano-material may be provided as a thin film typically having a thickness of 100 nanometers or less.

Nano-materials made according to the invention are advantageous because the clusters of non-magnetic substance prevent the formation of large crystalline grains of the ferro-magnetic substance. The non-magnetic clusters surround the magnetic grains limiting the grain size of the ferro-magnetic substance, as compared to the grain size which would occur if the substance had been produced using direct atomic deposition. With the present invention the magnetic material grain size can be reduced to close to the superparamagnetic limit. The reduction in grain size has several beneficial effects, particularly when the material is used as a magnetic media used, for instance, to store data.

The reduced grain size provides faster switching of the magnetism of each grain of the ferro-magnetic substance, since the magnetic moments required to switch the magnetism are reduced. This allows faster reading/writing when the material is used as a magnetic data storage medium. The increased density of ferro-magnetic grains which results from the reduced grain size also allows an increased density of data to be stored. In addition, the separation of magnetic grains by the non-magnetic clusters to some extent magnetically de-couples adjacent grains.

The reduced grain size also substantially increases the hardness of the nano-material. This can be of benefit in increasing wear resistance, particularly where the material is provided as a thin film, for instance if used as the data storage medium of a computer hard disc additional protective coatings may not be required.

Preferably, the non-magnetic clusters are embedded at a density of less than 20% by volume into the matrix of ferro-magnetic substance, and most preferably at a density less than 10% by volume.

Preferably, a majority of the non-magnetic clusters have diameters of less than 10 nano meters, for instance between 1 and 7 nanometers.

Preferably, a majority of grains of the ferro-magnetic substance are less than 20 nanometers in diameter. For instance the grain size may be of the order of 10 nanometers in diameter the minum size being determined by the superparamagnetic limit of the particular magnetic substance used.

Preferably, the ferro-magnetic substance is cobalt. Any other suitable ferro-magnetic substance may however be used, for example iron.

Preferably, the non-magnetic substance is a substance that will not dissolve in the ferro-magnetic substance. Any elemental non-magnetic substance which is immiscible in the ferro-magnetic substance may be used.

Preferably, the non-magnetic substance is copper. Copper is preferred because it does not dissolve in cobalt but it will be appreciated that there are other substances that could be used.

The surface may be provided by any suitable substrate such as a silicon or a metal, although any suitable substrate may be used. The thin film nano-material may be deposited directly onto a conventional computer hard disk surface for instance.

The thin film nano-material may comprise one single layer of a multi-layer material.

Preferably, the atoms of the ferro-magnetic substance and the clusters of the non-magnetic substance are generated at separate sources.

Preferably, the atoms of the ferro-magnetic substance are generated in a first magnetron. The atoms are preferably directed to the surface in a jet of argon atoms. This is atomic deposition.

Preferably, atoms of the non-magnetic substance are generated in a second magnetron, and group together to form clusters in a cooled chamber. The clusters are preferably directed to the surface in a jet of argon atoms.

According to a second aspect of the invention there is provided a thin film nano-material comprising a polycrystaline matrix of ferro-magnetic grains surrounded by clusters of atoms of a non-magnetic substance.

A specific embodiment of the invention will now be described with reference to the accompanying figure, which shows schematically an apparatus capable of producing the thin film nano-material according to the invention.

In one example of the invention, copper clusters having diameters between 1.5 nanometers and 7 nanometers are embedded into a matrix of ferro-magnetic cobalt. These clusters prevent the formation of large crystalline grains of cobalt, the grains being typically less than approximately 20 nanometers in diameter, rather than 50 to 60 nanometers that would form in the absence of the copper clusters. A further advantage of such small cobalt grains in addition to those mentioned above is that they are stable, as compared to cobalt grains of 50 to 60 nanometers diameter which are liable to grow when subjected to a magnetic field.

Magnetic nano-materials according to the present invention are particularly suitable for use as magnetic storage media.

As mentioned above the increased density of cobalt grains allows an increased density of data to be stored, and perhaps more significantly the reduced grain size provides faster switching of the magnetism of each cobalt grain, since the magnetic moments required to switch the magnetism are reduced. This allows faster reading/writing to the data storage medium.

Other advantages of the cobalt and copper of the present invention film include improved stability and hardness.

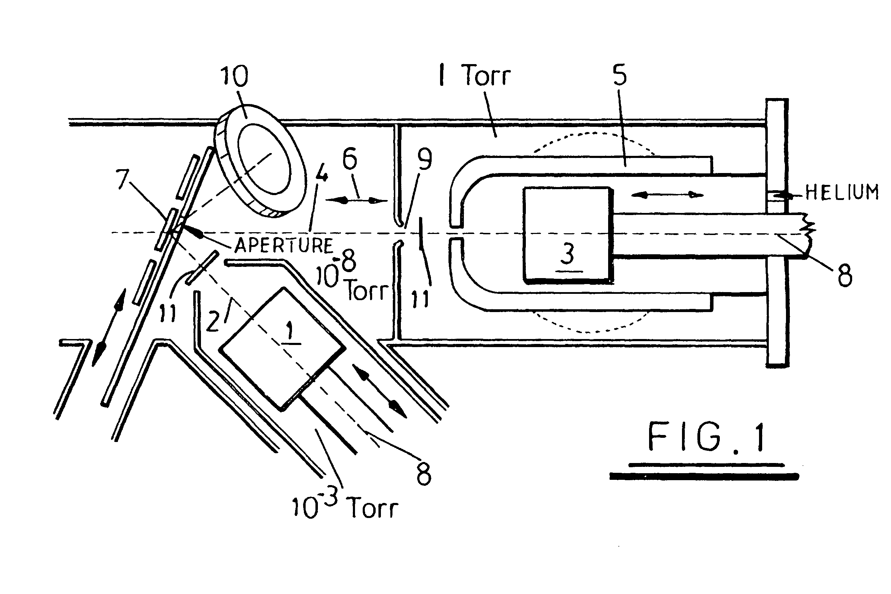

A magnetron sputtering apparatus which may be used to produce the cobalt and copper film is illustrated in Figure 1. A first magnetron 1 provides a jet of atomic cobalt 2, and a second magnetron 3 provides a jet of copper clusters 4.

Inside the first magnetron 1 is a plate bearing cobalt (not shown). A magnet (not shown) situated behind the plate produces a magnetic field in front of the plate. The plate forms a cathode, and suitably located anodes (not shown) are placed around the plate. Low pressure argon gas is introduced into the magnetron in a continuous stream 8. The argon gas is ionised by the electric field inside the magnetron 1, and electrons which are separated from the argon atoms strike the cathode plate, thereby knocking cobalt atoms from the plate. These cobalt atoms are sputtered atoms. The cobalt atoms are carried from the magnetron 1 by a jet of argon atoms, such that the jet of atomic cobalt 2 in fact comprises atomic cobalt and atomic argon. The presence of the argon in the jet 2 may be ignored since it is inert.

The second magnetron 3 is similarly constructed to the first magnetron 3, a constant stream of low pressure argon gas 8 again being introduced into the magnetron 3. However, in this case the plate (not shown) bears copper rather than cobalt.

The beam of atomic cobalt 2 is produced in a vacuum of 10⁻³ Torr. In contrast to this, the second magnetron 3 is located inside a chamber 5 containing a mixture of helium and argon at a pressure between 0.1 and 1.5 mbar (typically 1 Torr). The chamber 5 is cooled by liquid nitrogen. Copper atoms are emitted from the second magnetron 3 into the chamber 5, and have a restricted mobility due to the presence of the helium and argon atoms. The copper atoms tend to drift together and stick together, thereby forming clusters; a process known as gas aggregation. The copper clusters leave the chamber 5 with the helium atoms and argon atoms in a supersonic jet. A skimmer 6 is provided to skim off the helium, which rapidly expands as it leaves the cooled chamber 5, thereby leaving a jet 4 of copper clusters and argon atoms. Again, the presence of the argon atoms in the jet 4 may be ignored, since they are inert.

Focusing lenses are not required to produce the jet of copper clusters 4. Instead, an appropriately funnelled hole 9 is used. Both the jet of cobalt atoms 2 and the jet of copper clusters 4 may be stopped using shutters 11.

Copper clusters are deposited together with cobalt atoms onto a suitable substrate 7, a process known as vacuum deposition. The substrate is held at a vacuum of 10⁻⁸ Torr to prevent impurities being deposited onto the substrate 7.

The atomic cobalt deposition and copper cluster deposition occur at the same time so that a cobalt matrix grows up around the copper cluster sites. The cobalt atomic beam is approximately ten to twenty times more intense than the copper cluster beam. The deposition rates are monitored using a stabilised oscillating-crystal thickness monitor (not shown).

The size of the copper clusters provided by the apparatus of Figure 1 may be selected from the range 1.5 nanometers to 7 nanometers, by appropriate adjustment of the apparatus. The full width half maximum of the cluster size distribution is approximately 30% of the average size. The deposition rate for the clusters is up to 5 A/s. The deposition rate provided by the apparatus is ultimately limited only by the source of the atomic cobalt jet 2.

It is known that the nature of a substrate may affect the nature of a thin film of ferro-magnetic material provided on that substrate. In this instance, by choosing a particular substrate which will act as a former to direct the growth of cobalt grains in one particular direction, the magnetism of the cobalt can be constrained to be into or out of the plane of the layer.

Properties of the cobalt and copper film can be manipulated easily and in a systematically repeatable manner by carefully controlling the size and density of the copper clusters.

The cobalt and copper film is hard because the grain size of the cobalt is limited to less than approximately 20 nanometers. Existing cobalt films, which do not include copper clusters, have a grain size of 50 to 60 nanometers, and consequently are significantly less hard. Conventional magnetic hard disks comprise a cobalt alloy film having a grain size smaller than 50 to 60 nanometers, and include a protective layer on top of the cobalt film in order to prevent damage by the recording head of the cobalt film. A magnetic hard disk constructed using the cobalt and copper film according to the invention would not require a protective layer and would therefore be simpler and cheaper to produce than existing magnetic hard disks.

A low density of copper clusters, of the order of 10% or less (by volume), is required to avoid adversely affecting the magnetic properties of the film. A copper cluster density of 5% to 10% is preferred. A cluster density of more than 20% may significantly inhibit the ability of the film to record magnetic information.

Tile substrate 7 can be any suitable substance, for example glass, silicon (or some other semi-conductor wafer or a metal). It is envisaged that in the manufacture of magnetic hard disks, the copper clusters and cobalt atoms will be deposited directly onto a hard disk.

Multi-layer materials, with one layer containing clusters, may be made using the apparatus shown in Figure 1. A thermal atomic source, for example a K-cell 10, may be used to produce atoms for vacuum deposition of a layer not containing clusters.

Copper cluster sizes can be changed by adjusting parameters within the second magnetron 3, such as the pressure of the helium and argon gases, and the positioning of the second magnetron 3 within the cooled chamber 5.

The rate of deposition is dependent upon the source of atoms and the source of clusters. The deposition rates quoted above are for an experimental apparatus. If the apparatus were scaled up to provide coating of hard disks, then the deposition rates will be increased, for example to the range 50-100 A/s.

Although the invention has been described with reference to cobalt other magnetic materials could be used. Cobalt however currently predominates on the production of magnetic data storage media. Similarly other non-magnetic materials, such as gold and chromium, cold be used instead of copper. These are non-limiting examples.

## Claims

1. A method of making a thin film nano-material, the method comprising simultaneously depositing atoms of a ferro-magnetic substance together with clusters of a non-magnetic substance onto a surface, thereby providing a thin film nano-material comprising a polycrystalline matrix of grains of the ferro-magnetic substance surrounded by clusters of atoms of the non-magnetic substance.

2. A method according to claim 1, wherein the non-magnetic clusters are embedded at a density of less than 20% by volume into the matrix of ferro-magnetic substance.

3. A method according to claim 2, wherein the non-magnetic clusters are embedded at a density of less than 10% by volume into the matrix of ferro-magnetic substance.

4. According to any preceding claim, wherein a majority of the non-magnetic clusters have diameters of less than 10 nanometers.

5. A method according to claim 4, wherein a majority of the non-magnetic clusters have diameters of less than 7 nanometers.

6. A method according to any preceding claim, wherein a majority of grains of the ferro-magnetic substance are less than 20 nanometers in diameter.

7. A method according to any claim 6, wherein a majority of grains of the ferro-magnetic substance are of the order of 10 nanometers in diameter.

8. A method according to any preceding claim, wherein the ferro-magnetic substance is cobalt.

9. A method according to any preceding claim, wherein the non-magnetic substance is a substance that will not dissolve in the ferro-magnetic substance.

10. A method according to any preceding claim, wherein the non-magnetic clusters are copper.

11. A method according to any preceding claim, wherein the surface is a silicon substrate, glass or a metal.

12. A method according to any preceding claim, wherein the thin film nano-material comprises a single layer of a multi-layer material.

13. A method according to any preceding claim, wherein the atoms of the ferro-magnetic substance and the clusters of the non-magnetic substance are generated at separate sources.

14. A method according to claim 13, wherein the atoms of the ferro-magnetic substance are generated in a first magnetron.

15. A method according to claim 13 or 14, wherein atoms of the non-magnetic substance are generated in a second magnetron, and group together to form clusters in a cooled chamber.

16. A thin film nano-material comprising a polycrystaline matrix of ferromagnetic substance surrounded by clusters of a non-magnetic substance.

## Patentansprüche

1. Verfahren zum Herstellen eines dünnen Folien-Nano-Materials, wobei das Verfahren umfaßt gleichzeitiges Ablagern von Atomen einer ferro-magnetischen Substanz zusammen mit Clustern einer nicht-magnetischen Substanz auf eine Oberfläche, dadurch zur Verfügung stellen eines dünnen Folien-Nano-Materials, umfassend eine polykristalline Matrix von Körnern der ferro-magnetischen Substanz, umgeben von Clustern von Atomen der nicht-magnetischen Substanz.

2. Verfahren nach Anspruch 1, wobei die nicht-magnetischen Cluster bei einer Dichte von weniger als 20 Volumen % in die Matrix von ferro-magnetischer Substanz eingebettet werden.

3. Verfahren nach Anspruch 2, wobei die nicht-magnetischen Cluster bei einer Dichte von weniger als 10 Volumen % in die Matrix von ferro-magnetischer Substanz eingebettet werden.

4. Verfahren nach einem vorhergehenden Anspruch, wobei eine Mehrheit der nicht-magnetischen Cluster Durchmesser von weniger als 10 Nanometer hat.

5. Verfahren nach Anspruch 4, wobei eine Mehrheit der nicht-magnetischen Cluster Durchmesser von weniger als 7 Nanometer hat.

6. Verfahren nach einem vorhergehenden Anspruch, wobei eine Mehrheit von Körnern der ferro-magnetischen Substanz weniger als 20 Nanometer an Durchmesser ist.

7. Verfahren nach einem vorhergehenden Anspruch 6, wobei eine Mehrheit von Körnern der ferro-magnetischen Substanz von der Ordnung von 10 Nanometern an Durchmesser ist.

8. Verfahren nach einem vorhergehenden Anspruch, wobei die ferro-magnetische Substanz Kobalt ist.

9. Verfahren nach einem vorhergehenden Anspruch, wobei die nicht-magnetische Substanz eine Substanz ist, die sich nicht in der ferro-magnetischen Substanz löst.

10. Verfahren nach einem vorhergehenden Anspruch, wobei die nicht-magnetischen Cluster Kupfer sind.

11. Verfahren nach einem vorhergehenden Anspruch, wobei die Oberfläche ein Siliciumsubstrat, Glas oder ein Metall ist.

12. Verfahren nach einem vorhergehenden Anspruch, wobei das dünne Folien-Nano-Material eine einzelne Schicht eines Multischichtmaterials umfaßt.

13. Verfahren nach einem vorhergehenden Anspruch, wobei die Atome der ferro-magnetischen Substanz und die Cluster der nicht-magnetischen Substanz bei separaten Quellen erzeugt werden.

14. Verfahren nach Anspruch 13, wobei die Atome der ferro-magnetischen Substanz in einem ersten Magnetron erzeugt werden.

15. Verfahren nach Anspruch 13 oder 14, wobei Atome der nicht-magnetischen Substanz in einem zweiten Magnetron erzeugt werden und sich unter Bilden von Clustern in einer gekühlten Kammer zusammen gruppieren.

16. Dünnes Folien-Nano-Material, umfassend eine polykristalline Matrix von ferro-magnetischer Substanz, umgeben von Clustern einer nicht-magnetischen Substanz.

## Revendications

1. Procédé de fabrication d'une nanomatière en film mince, le procédé comprenant le fait de déposer de manière simultanée des atomes d'une substance ferromagnétique avec des agglomérats d'une substance amagnétique sur une surface pour ainsi obtenir une nanomatière en film mince comprenant une matrice polycristalline de grains de la substance ferromagnétique entourée par des agglomérats d'atomes de la substance amagnétique.

2. Procédé selon la revendication 1, dans lequel les agglomérats amagnétiques sont incrustés en une densité inférieure à 20 % en volume dans la matrice de substance ferromagnétique.

3. Procédé selon la revendication 2, dans laquelle les agglomérats amagnétiques sont incrustés en une densité inférieure à 10 % en volume dans la matrice de substance ferromagnétique.

4. Procédé selon l'une quelconque des revendications précédentes, dans lequel la majorité des agglomérats amagnétiques possèdent des diamètres inférieurs à 10 nanomètres.

5. Procédé selon la revendication 4, dans lequel la majorité des agglomérats amagnétiques possèdent des diamètres inférieurs à 7 nanomètres.

6. Procédé selon l'une quelconque des revendications précédentes, dans lequel la majorité des grains de la substance ferromagnétique possèdent un diamètre inférieur à 20 nanomètres.

7. Procédé selon la revendication 6, dans lequel la majorité des grains de la substance ferromagnétique possèdent un diamètre inférieur à 10 nanomètres.

8. Procédé selon l'une quelconque des revendications précédentes, dans lequel la substance ferromagnétique est du cobalt.

9. Procédé selon l'une quelconque des revendications précédentes, dans lequel la substance amagnétique est une substance qui ne va pas se dissoudre dans la substance ferromagnétique.

10. Procédé selon l'une quelconque des revendications précédentes, dans lequel les agglomérats amagnétiques sont en cuivre.

11. Procédé selon l'une quelconque des revendications précédentes, dans lequel la surface est un substrat de silicium, du verre ou un métal.

12. Procédé selon l'une quelconque des revendications précédentes, dans lequel la nanomatière en film mince comprend une couche unique d'une matière multicouche.

13. Procédé selon l'une quelconque des revendications précédentes, dans lequel les atomes de la substance ferromagnétique et les agglomérats de la substance amagnétique sont générés à des sources séparées.

14. Procédé selon la revendication 13, dans lequel des atomes de la substance ferromagnétique sont générés dans un premier magnétron.

15. Procédé selon la revendication 13 ou 14, dans lequel les atomes de la substance amagnétique sont générés dans un deuxième magnétron et se regroupent pour former des agglomérats dans une chambre refroidie.

16. Nanomatière en film mince comprenant une matrice polycristalline d'une substance ferromagnétique entourée par des agglomérats d'une substance amagnétique.
